# EUROPÄISCHE PATENTSCHRIFT

(11) **EP 1 774 572 B1**
(45) Veröffentlichungstag und Bekanntmachung des Hinweises auf die Patenterteilung: **28.09.2016**
(21) Anmeldenummer: 05761141.0
(22) Anmeldetag: 01.07.2005
(51) Int. Cl.: H01L 21/3065, B81C 1/00, B81B 3/00, H01L 21/3213

(54) **VERFAHREN ZUM ÄTZEN EINER SCHICHT AUF EINEM SUBSTRAT**
METHOD FOR ETCHING A LAYER ON A SUBSTRATE
PROCÉDÉ POUR GRAVER UNE COUCHE SUR UN SUBSTRAT

(30) Priorität: 29.07.2004 DE 102004036803
(43) Veröffentlichungstag der Anmeldung: 18.04.2007
(73) Patentinhaber: ROBERT BOSCH GMBH, 70442 Stuttgart (DE)
(72) Erfinder: LÄRMER, Franz, 71263 Weil Der Stadt (DE); KRONMÜLLER, Silvia, 71409 Schwaikheim (DE); FUCHS, Tino, 72072 Tübingen (DE); LEINENBACH, Christina, 66806 Ensdorf (DE)
(86) Internationale Anmeldenummer: PCT/EP2005/053121
(87) Internationale Veröffentlichungsnummer: WO 2006/013137

(56) Entgegenhaltungen:
- WO-A-2004/070338
- WO-A-2004/108585
- DE-A1- 10 006 035
- DE-A1- 19 847 455
- FR-A- 2 857 952
- US-A1- 2002 153 808
- US-A1- 2003 215 989
- US-A1- 2004 235 262
- US-A1- 2005 191 795
- BOREL S ET AL: "Isotropic etching of SiGe alloys with high selectivity to similar materials" MICROELECTRONIC ENGINEERING, ELSEVIER PUBLISHERS BV., AMSTERDAM, NL, Bd. 73-74, Juni 2004 (2004-06), Seiten 301-305, XP004564616 ISSN: 0167-9317

## Beschreibung

Die vorliegende Erfindung betrifft ein Verfahren zum Ätzen einer zu entfernenden Schicht auf einem Substrat gemäß dem Oberbegriff des Anspruchs 1 wie aus der US 2003/0215989 A1 bekannt.

Die US 2002/0153808 A1 offenbart ebenfalls ein derartiges Verfahren zum Ätzen einer zu entfernenden Schicht auf einem Substrat.

Eine selektive Entfernung einer bestimmten Schicht wie beispielsweise einer Opferschicht auf einem Halbleitersubstrat ist eine bekannte Maßnahme im Herstellungsverfahren eines Halbleiterbauelementes, insbesondere bei einem Verfahren zur Herstellung von freitragenden Strukturen. So wird beim Herstellungsverfahren eines mikromechanischen Sensors eine Opferschicht auf dem Substrat gebildet, auf die eine weitere Strukturschicht abgeschieden und strukturiert wird. Anschließend wird die Opferschicht zur Freilegung der Strukturen selektiv entfernt. Grundsätzlich kann die Opferschicht trocken oder nasschemisch entfernt werden.

Aus der DE 195 37 814 A1 ist ein Sensor und ein Verfahren zur Herstellung eines Sensors bekannt, bei dem auf einem Siliziumsubstrat zunächst ein thermisches Oxid abgeschieden wird, auf das weiter eine dünne Schicht hochdotierten Polysiliziums zur Verwendung als vergrabene Leiterbahn aufgebracht wird. Daraufhin wird auf der Polysiliziumschicht eine weitere Oxidschicht und hierauf beispielsweise eine dicke Epipolysiliziumschicht abgeschieden. Hiernach erfolgt die Abscheidung und Strukturierung einer oberflächlichen Aluminiummetallisierung. Abschliessend werden die freizulegenden Sensorstrukturen, vorzugsweise mit einem in der DE 42 41 045 C1 beschriebenen fluorbasierten Siliziumtiefenätzverfahren herausgeätzt. Die Freilegung des Sensorelementes geschieht mittels einer Opferschichtätzung, bei der das Oxid typischerweise durch flusssäurehaltige Medien über ein Dampfätzverfahren unter den Sensorbereichen entfernt wird. Nachteilig bei dieser Unterätztechnik ist, dass das Oxid nicht nur unter dem freizulegenden Sensorbereich entfernt wird, sondern auch über und teilweise auch unter den Polysilizium-Leiterbahnen, so dass die Gefahr von Nebenschlüssen und Kriechströmen besteht. Ein Schutz der Oxidbereiche, deren Unterätzung verhindert werden soll, etwa durch Schutzlacke, ist nur mit erheblichen Aufwand möglich, da dampfförmige Flusssäure nahezu alle praktikablen polymeren Schutzschichten sehr schnell durchdringt und überdies stark korrosiv wirken kann.

Die durch die Verwendung der dampfförmigen Flusssäure auftretenden Probleme können vermieden werden, indem die Unterätzung der Sensorelemente mittels Plasmaätzverfahren durchgeführt wird. So wird beispielsweise in DE 44 20 962 A1 ein Trockenätzverfahren in Silizium zur Herstellung von Sensorstrukturen vorgeschlagen, bei dem durch eine Kombination von anisotroper und isotroper Plasmaätztechnik auf einen nachträglichen Nassätzschritt oder ein Ätzen in der Dampfphase verzichtet werden kann. Auch ist eine separate Opferschicht nicht vorgesehen. Alle Prozessschritte können in einer einzigen Plasmaätzanlage durchgeführt werden. Dazu wird zunächst wieder mit Hilfe des in der DE 42 41 045 C1 beschriebenen anisotropen Tiefenätzverfahrens die Sensorstruktur mit vertikalen Wänden erzeugt. Dabei wechseln Depositionsschritte, bei denen auf der Seitenwand ein teflonartiges Polymer abgeschieden wird, und an sich isotope, fluorbasierte Ätzschritte, die durch Vorwärtstreiben des Seitenwandpolymers während der Ätzung lokal anisotrop gemacht werden, einander ab. Anschliessend wird mit einem fluorbasierten Ätzschritt das Siliziumsubstrat so lange isotrop eingeätzt, bis die Siliziumstruktur für das Sensorelement vollständig freigelegt ist.

Dieses Verfahren hat jedoch zwei gravierende Nachteile. Einerseits kommt es infolge des sogenannten "Microloading-Effektes" dazu, dass schmale Ätzgräben langsamer als breite Ätzgräben geätzt werden, was dann auch für die Geschwindigkeit der nachfolgenden lateralen Unterätzung gilt, d. h. die Unterätzung schreitet bei schmalen Gräben langsamer voran als bei breiten Gräben. Zum anderen werden die freizulegenden Strukturen auch von ihrer Unterseite bzw. Boden angegriffen. Dies hat zur Folge, dass Strukturen, die von breiten Trenchgräben umgeben sind, eine geringere Resthöhe haben als Strukturen, die von schmalen Trenchgräben umgeben sind, was häufig zu nicht reproduzierbaren und unbefriedigenden mechanischen Eigenschaften der hergestellten Sensorelemente führt.

Um eine definierte Unterätzung zu ermöglichen, und somit die Nachteile des Verfahrens aus DE 44 20 962 A1 zu beseitigen, kann das Verfahren aus DE 198 47 455 A1 eingesetzt werden. Auch hier wird durch eine Kombination von anisotroper Plasmaätzung zur Strukturierung der Sensorelemente und anschliessender Unterätzung von derselben mittels isotroper Gasphasenätzung oder isotroper Fluor-Plasmaätzung ganz auf Flusssäuredampf verzichtet. In diesem Verfahren wird jedoch eine nur wenige zehn Nanometer dünne Oxidebene direkt oberhalb einer Polysilizium-Opferschichtebene im Bereich der zu erzeugenden Sensorstruktur als eine Trennschicht benutzt. Auf die dünne Oxidebene wird eine Epi-Polysilizium-Schicht abgeschieden und mittels des in DE 42 41 045 C1 beschriebenen anisotropen Tiefenätzverfahrens strukturiert. Die dünne Oxidebene wirkt dabei als ein harter Ätzstopp, die anschliessend selbst durch ein Plasmaätzen mit fluorreichen Ätzgasen wie CF₄ oder C₂F₆ unter intensivem Ionenbeschuss, d. h. unter hoher Substrat-Biasspannung, entfernt wird. Nachfolgend werden die Seitenwände der Sensorstrukturen mit einem teflonartigen Polymer oder einem Si-Oxiddünnschicht als Schutzschicht überzogen, bevor die Strukturelemente aus Epi-Polysilizium durch isotrope Gasphasenunterätzung z. B. mit ClF₃ oder auch durch eine isotrope Fluorplasma-Unterätzung freigelegt werden. Wegen der hohen Selektivität dieses Ätzschrittes von mindestens 200-300:1 gegenüber Siliziumoxid verhindert die Oxidebene auf der Unterseite der Strukturelemente und gegebenenfalls auch auf den Seitenwänden deren rückseitige Anätzung bzw. seitlichen Ätzangriff.

Allerdings induziert das rückseitige Oxid eine Druckspannung und eine Verwölbung der Strukturelemente nach oben. Daraus resultiert eine nachhaltige Beeinflussung der mechanischen Eigenschaft der Strukturelemente durch das Oxid. Um diesen Störeffekt zu minimieren, sollte die Oxidebene möglichst dünn, etwa 10 nm, ausgebildet sein. Die Praxis zeigt zudem, dass die teflonartige oder wie auch immer geartete Schutzschicht auf den Strukturseitenwänden oft nicht ausreicht, um deren Ätzangriff während des isotropen Gasphasen- oder Plasmaätzschrittes zu vermeiden. Selbst eine Oxidschicht anstelle der Teflonpassivierung, die in einem kostenintensiven Abscheide-Verfahren aufgebracht werden muss, reicht nicht aus, um die notwendige ProzessSicherheit gewährleisten zu können. Nach Freilegung der Sensorstruktur ist dann diese Oxidschicht an den Strukturseitenwänden wieder zu entfernen, weshalb die problematische Einwirkung durch Flusssäure oder Flusssäuredampf auf die Sensorstrukturen dann letztlich doch Anwendung findet.

### Vorteile der Erfindung

Gemäß der Erfindung wird ein Verfahren nach den Ansprüchen 1-15 vorgeschlagen. Das erfindungsgemäße Verfahren gemäß Anspruch 1 beruht darauf, dass eine Schicht aus Silizium-Germanium-Legierung auf einem Substrat bei einem Gasphasenätzen mit Hilfe eines Ätzgases abgetragen werden kann, insbesondere hochselektiv gegenüber einem Substrat aus Silizium. Insbesondere wird vorgeschlagen, als ein besonders vorteilhaftes Ätzgas CIF₃ einzusetzen. Auch kann das Ätzverhalten der Si₁₋ₓGeₓ-Schicht über den Ge-Anteil in der Legierung gesteuert werden.
Wird eine Si₁₋ₓGex-Schicht insbesondere als eine Opferschicht zur Herstellung eines mikromechanischen Sensors angewendet und die Opferschicht durch Gasphasenätzung entfernt, so werden oben beschriebene Nachteile bezüglich der Entfernung der Opferschicht umgangen. Das erfindungsgemäße Verfahren kann völlig auf eine Ätzung einer Siliziumoxidschicht durch flusssäurehaltige Medien verzichten, so dass eine ungewollte, aber unvermeidbare Ätzung von Schutzschichten ober- oder unterhalb von Polysilizium-Leiterbahnen nicht stattfindet. Eine Gefahr von Nebenschlüssen und Kriechströmen besteht daher nicht. Auch wird die Prozesssicherheit dadurch verbessert, dass keine Abhängigkeit mehr von Seitenwandschutzschichten besteht, da beim erfindungsgemäßen Ätzverfahren eine sehr hohe materialbedingte Selektivität der Struktur- zu Opferschicht vorliegt.

Weiter kann eine Si₁₋ₓGeₓ-Schicht auch als eine Füllschicht auf einem Substrat abgeschieden und zur Erzeugung eines Hohlraumes nach einer Abscheidung einer Kappenschicht auf das Substrat durch eine Gasphasenätzung in einer einfachen Weise entfernt werden.

Durch die in den abhängigen Ansprüchen aufgeführten Maßnahmen sind vorteilhafte Weiterbildungen und Verbesserungen des Verfahrens nach dem unabhängigen Anspruch möglich.

### Zeichnungen

Ausführungsbeispiele der Erfindung sind in den Zeichnungen dargestellt und in der nachfolgenden Beschreibung näher erläutert.

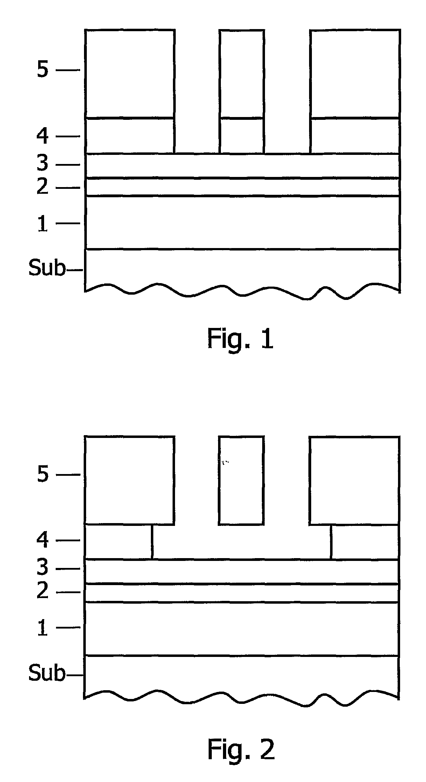

Es zeigen die Figuren 1 und 2 das erfindungsgemäße Verfahren zur selektiven Ätzung einer Schicht auf einem Substrat, wobei Figur 1 ein mikromechanisches Sensorelement vor und Figur 2 nach der Entfernung der Si₁₋ₓGeₓ-Opferschicht jeweils im Schnitt darstellt.

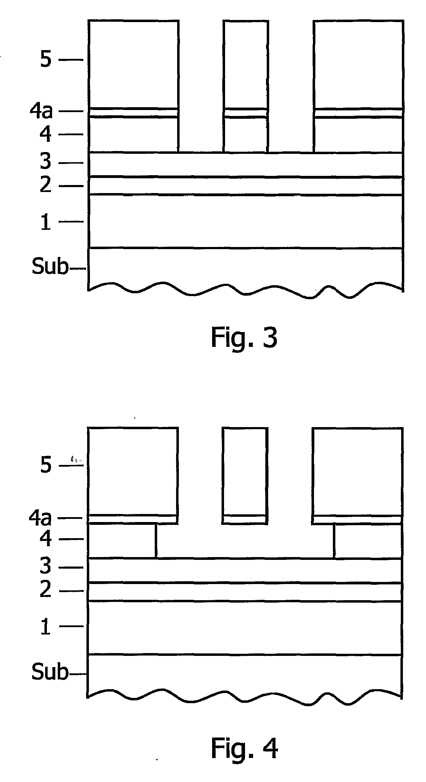

Weiter zeigen die Figuren 3 und 4 eine zweite Möglichkeit bezüglich des Schichtaufbaus eines Sensorelementes, wobei Figur 3 ein mikromechanisches Sensorelement vor und Figur 4 nach der Entfernung der Si₁₋ₓGeₓ-Opferschicht jeweils im Schnitt darstellt.

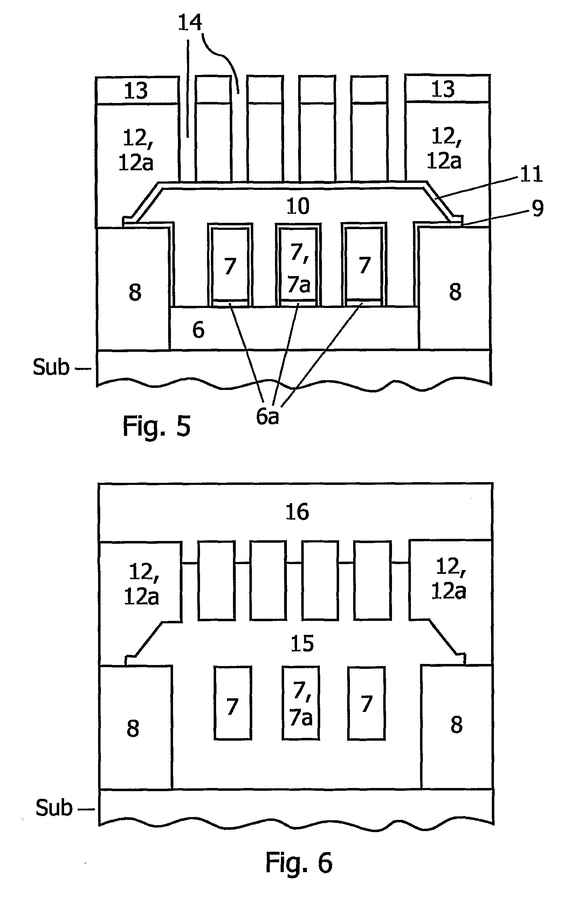

Schließlich zeigen Figuren 5 und 6 eine dritte Möglichkeit bezüglich des Schichtaufbaus eines Sensorelementes, wobei Figur 5 ein mikromechanisches Sensorelement vor und Figur 6 nach der Entfernung der Si₁₋ₓGeₓ-Opfer- und Si₁₋ₓGeₓ-Füllschicht jeweils im Schnitt darstellt. Beschreibung der Ausführungsbeispiele

Das erfindungsgemäße Verfahren wird zunächst beispielhaft in einem Herstellungsprozess eines mikromechanischen Sensors demonstriert. Zur Herstellung des in der Figur 1 gezeigten Schichtsystems wird auf einem Siliziumsubstrat Sub zunächst eine erste Isolationsschicht 1, typischerweise ein dickes thermisches Isolationsoxid, abgeschieden. Eine mögliche Dicke dieser Oxidschicht liegt im Bereich von einigen wenigen Mikrometern, beispielsweise 2,5 µm.

Darüber wird eine Leitschicht 2, bevorzugterweise eine dünne Polysilizium-Schicht in einer Dicke von etwa 0,5 µm, aufgebracht. Es sind jedoch auch andere Schichtmaterialien vorstellbar, beispielsweise kann die Isolationsschicht 1 auch aus anderen Oxiden, Siliziumnitrid oder anderen Isolationsschichten bestehen. Für die Leitschicht 2 sind neben Polysilizium auch metallische Schichten geeignet, wenn dabei Materialien gewählt werden, die für die nachfolgenden Hochtemperaturschritte unkritisch sind, wie beispielsweise Wolfram oder Wolframlegierungen. Die Leitschicht 2, die hier wie bereits erwähnt aus Polysilizium besteht, wird durch Dotierung aus der Gasphase (POCl₃) dotiert, wobei dabei eine große Leitfähigkeit angestrebt wird. Es sind auch alle anderen Prozesse zur Erzeugung einer ausreichend stark dotierten Polysilizium-Schicht verwendbar.

Durch einen fotolithografischen Prozeß erfolgt dann eine Strukturierung der Leitschicht 2. Die Leitschicht 2 wird so in einzelne gegeneinander isolierte Bereiche unterteilt, die beispielsweise als Leiterbahnen oder Elektroden dienen können.

Auf dem Substrat Sub wird dann eine zweite Isolationsschicht 3 abgeschieden. Für das Abscheiden dieser Schicht können die aus der Halbleitertechnik bekannten Abscheideprozesse zur Abscheidung von dielektrischen Schichten genutzt werden. Neben Siliziumdioxid können somit auch Siliziumnitrid, verschiedene Gläser oder andere keramische Schichten abgeschieden werden. Für die weitere Beschreibung wird davon ausgegangen, dass die zweite Isolationsschicht 3 ebenfalls aus Siliziumoxid besteht.

Nun wird als Opferschicht eine Si₁₋ₓGeₓ-Schicht 4 auf die zweite Isolationsschicht 3 abgeschieden. Die Dicke der Si₁₋ₓGeₓ-Schicht 4 beträgt wenige Mikrometer, beispielsweise 1,5 µm. Der Gehalt von Germanium in der Si₁₋ₓGeₓ-Legierung kann je nach Bedarf variiert werden, ein möglicher Wertebereich für x ist der Bereich von x = 0,05 bis x = 0,5, insbesondere x = 0,1 bis x = 0,5. Im Falle x = 0,5 ist der Anteil von Germanium und Silizium in der gemeinsamen Legierung gleich groß. Für bestimmte Anwendungen kann ein Wertebereich mit einem kleineren oberen Grenzwert für x, beispielsweise ein Bereich von x = 0,05 bis x = 0,3, insbesondere x = 0,1 bis x = 0,3, geeignet sein. Wichtig ist die Abhängigkeit des Schmelzpunkts der SiGe-Legierung vom Ge-Anteil. Mit wachsendem Ge-Anteil nimmt der Schmelzpunkt ab. Für x = 1, also Ge selbst, liegt der Schmelzpunkt bei 940 °C. Für x = 0, also Si selbst, liegt der Schmelzpunkt bei 1414 °C. Entsprechend bewegt sich der Schmelzpunkt der Si₁₋ₓGeₓ-Legierung für x = 0,05 bis x = 0,5 zwischen diesen Werten: er muss mit den nachfolgenden Hochtemperatur-schritten kompatibel sein.

Als letzte Schicht wird auf die Si₁₋ₓGeₓ-Schicht 4 eine dicke Siliziumschicht 5 aufgebracht. Bevorzugterweise wird als die Siliziumschicht 5 eine Polysilizium-Schicht epitaktisch, sog. EpiPoly-Si, abgeschieden. In einzelnen bedeckt zunächst eine Polysilizium-Startschicht die Oberfläche der Si₁₋ₓ-Geₓ-Schicht 4 und dient als Keim für die nachfolgende Abscheidung. Durch einen entsprechenden Dotierungsprozeß, beispielsweise durch Implantation oder durch Eintreiben von Dotierstoffen aus der Gasphase, kann eine eventuell benötigte Dotierung der Polysilizium-Startschicht sichergestellt werden. Zur Abscheidung der Polysilizium-Startschicht sind alle in der Halbleitertechnik gebräuchlichen Methoden zur Abscheidung von dünnen Polysilizium-Schichten geeignet.

In einem weiteren Prozeßschritt erfolgt dann die Abscheidung der eigentlichen Siliziumschicht 5. Diese Abscheidung erfolgt in einem Epitaxiereaktor. Bei einem derartigen Epitaxiereaktor handelt es sich um eine Anlage zum Abscheiden von Siliziumschichten, die in der Halbleitertechnik zur Erzeugung von einkristallinen Siliziumschichten auf einem einkristallinen Siliziumsubstrat verwendet werden. Die Abscheidung derartiger Schichten erfolgt in der Regel bei Temperaturen von mehr als 1000 Grad Celsius und es können so Schichtdicken in einer Größenordnung von einigen 10 Mikrometern erreicht werden. Da beim vorliegenden Prozeß die Abscheidung im Epitaxiereaktor nicht auf einem einkristallinen Siliziumsubstrat, sondern auf der polykristallinen Silizium-Startschicht erfolgt, bildet sich keine einkristalline Siliziumschicht aus, sondern eine dicke polykristalline Siliziumschicht 5, sog. EpiPoly-Silizium, die im folgenden als dicke Siliziumschicht 5 bezeichnet wird. Durch die Abscheidebedingungen, mit denen die polykristalline Silizium-Startschicht erzeugt wird, lassen sich die kristallinen Eigenschaften der dicken Siliziumschicht 5 beeinflussen. Weiterhin bewirkt die starke Dotierung der Polysilizium-Startschicht eine Dotierung der dicken Siliziumschicht 5 ausgehend von der Unterseite. Weiterhin erfolgt während des Aufwachsens der dicken Siliziumschicht 5 und in einem nachfolgenden Dotierungsprozess nach dem Aufwachsen eine weitere Dotierung der dicken Siliziumschicht 5. Die nachfolgende Dotierung der dicken Siliziumschicht 5 kann wiederum durch Implantation, Dotierung aus der Gasphase oder jeden anderen aus der Halbleitertechnik bekannten Dotierungsprozess erfolgen. Die Polysilizium-Startschicht wird bei diesem Prozeß Teil der dicken Siliziumschicht 5. Im Bereich von in den Figuren 1 und 2 nicht dargestellten Kontaktlöchern weist die dicke Siliziumschicht 5 einen unmittelbaren Kontakt mit der Leitschicht 2 auf.

Auf der Oberseite der dicken Siliziumschicht 5 wird dann noch eine Metallschicht aufgebracht und strukturiert, die in den Figuren 1 und 2 aus Übersichtlichkeitsgründen nicht dargestellt wurden. Die Metallschicht kann beispielsweise ganzflächig aufgebracht und anschließend strukturiert werden.

In einem weiteren fotolithografischen Prozess erfolgt dann eine Strukturierung der dicken Siliziumschicht 5, wie dies in der Figur 1 gezeigt ist. Dazu wird auf der Oberseite der Siliziumschicht 5 eine Maske, beispielsweise eine Fotomaske, aufgebracht, die auch einen Schutz der Metallschicht in der nachfolgenden Ätzung bewirkt. Durch Öffnungen der Fotolackmaske hindurch erfolgt dann beispielsweise ein Tiefenätzverfahren auf Fluorbasis in separaten, jeweils alternierend aufeinanderfolgenden Ätz- und Polymerisationsschritten nach der Lehre aus DE 42 41 045 C1. Durch diesen Tiefenätzprozess können Gräben mit einem hohen Aspektverhältnis, d. h. mit großer Tiefe und geringer lateraler Abmessung, erzeugt werden.

Die Gräben erstrecken sich von der Oberseite der dicken Siliziumschicht 5 bis zur Oberseite der zweiten Isolationsschicht 3. Die Siliziumschicht 5 wird so in einzelne Bereiche unterteilt, die gegeneinander isoliert sind, sofern sie nicht über die Leitschicht 2 miteinander verbunden sind.

Durch die Gräben hindurch wird dann erfindungsgemäß bei einem Gasphasenätzen ein Ätzgas an die Si₁₋ₓGeₓ-Schicht 4 herangeführt, wobei das Ätzgas eine hochselektive Ätzung der Si₁₋ₓGeₓ-Schicht 4 bewirkt. Als Ätzgas wird neben BrF₃ und XeF₂ bevorzugt ClF₃ eingesetzt. In dieser Kombination, d. h. ClF₃ als Ätzgas bei einer zu entfernenden Schicht aus Si₁₋ₓGeₓ, beträgt die ausserordentlich hohe Selektivität gegenüber Epi-Polysilizium etwa 4000:1 und gegenüber SiO₂ etwa 100000:1. In der Praxis wurde weiter festgestellt, dass sich dabei das Ätzverhalten, insbesondere die Ätzgeschwindigkeit, durch den Germanium-Anteil in der Legierung äußerst effektiv steuern lässt. Je größer der Germanium-Anteil in der Si₁₋ₓGeₓ-Legierung bis zu Werten von etwa x = 0,3 als eine obere Grenze, desto schneller wird geätzt. Ab einem Ge-Anteil von etwa 30 Prozent, d. h. in einem Wertebereich von x = 0,3 bis x = 0,5 bleibt die Ätzgeschwindigkeit nahezu konstant. In der Summe wird dadurch ein kontrollierter, d. h. in der Ätzgeschwindigkeit steuerbarer und in der Materialkombination ein hochselektiver Ätzangriff ermöglicht.

Nach einer bereichsweisen Entfernung der Si₁₋ₓGeₓ-Schicht 4 unter dem strukturierten Sensorelement aus Epi-Polysilizium ist wie in Figur 2 dargestellt das ebengenannte Sensorelement vollständig unterätzt und somit freigelegt.

Während der Opferschichtätzung konnten vorteilhaft in der Figur 2 nicht dargestellte Kontaktpads aus einem Metall wie Aluminium durch die gleiche Photolackmaske geschützt werden, die bereits zuvor während des anisotropen Plasmaätzens als Schutzmaske gedient hatte. Es ist also nicht nur ein vermindertes Korrosionsrisiko durch die vollständige trockene Prozesschemie gegeben, sondern auch ein vollständiger Schutz der Al-Kontaktpads durch die Lackmaske, die zuvor schon als Trenchmaske diente.

Nach dem Ausschleusen aus einer Ätzanlage wird das Substrat Sub in einem Sauerstoffplasma-Stripper von der Photolackmaske und den verbliebenen teflonartigen Seitenwandfilmen befreit. Dieser Veraschungsprozess mit einem Sauerstoffplasma ist in der Halbleiterindustrie eine bekannte Maßnahme zur Entfernung von Lackresten und Prozessrückständen aus vorangegangenen Plasma-Ätzschritten.

Eine besonders vorteilhafte Ausführungsform des erfindüngsgemäßen Ätzverfahrens zeigen die Figuren 3 und 4. Ergänzend zum bisher beschriebenen Aufbau des mikromechanischen Sensors ist eine Diffusionsbarriere 4a zwischen der Si₁₋ₓGeₓ-Schicht 4 und der oberen Si-Schicht 5 vorgesehen. Mit der Diffusionsbarriere 4a wird ein Ausdiffundieren von Germanium in die obere Si-Schicht 5 verhindert. Die Diffusionsbarriere 4a ist eine dünne Si-Oxidschicht oder eine Si-Nitridschicht mit einer Dicke von nur typischerweise 10 bis 100 nm. Eine so dünne Schicht aus Si-Oxid oder Si-Nitrid ist deshalb ausreichend, weil sie hier als eine Diffusionsbarriere dient, aber keine Passivierung gegenüber einem Ätzgas, insbesondere ClF₃, gewährleisten muss.

In einem weiteren Ausführungsbeispiel kann das erfindungsgemäße Verfahren eingesetzt werden bei der Herstellung eines mikromechanischen Bauelementes, das mindestens einen Hohlraum mit einer beweglichen Struktur aufweist. Im wesentlichen wird, wie in Figuren 5 und 6 dargestellt, zwei Si₁₋ₓGeₓ-Schichten jeweils als Opfer- bzw. Füllschicht in einem Bereich mit Sensorelementen auf einem Substrat abgeschieden und zur Erzeugung eines Hohlraumes nach einer Abscheidung einer Kappenschicht auf das Substrat entfernt.

Im einzelnen wird entsprechend der Lehre aus beispielhafterweise DE 100 06 035 A1 bei der Herstellung des Sensors auf einem Substrat Sub eine erste Opferschicht und darauf eine Siliziumschicht 7 abgeschieden und anschließend strukuriert zu Sensorelementen. In diesem Beispiel wird das mittlere Sensorelement 7a nach Prozessende eine bewegliche Struktur bilden. Jedoch wird entgegen dem bekannten Verfahren aus der genannten Schrift vorgeschlagen, als die erste Opferschicht nicht Siliziumoxid, sondern erfindungsgemäß eine Si₁₋ₓGeₓ-Schicht 6 abzuscheiden. Durch eine Vorstrukturierung der Opferschicht können bei der Abscheidung und Strukturierung der Siliziumschicht 7 auch Verankerungen zum Substrat Sub, sog. Stützstrukturen 8, erzeugt werden. Bevorzugt wird noch vor der Abscheidung der Siliziumschicht 7 eine Diffusionsbarriere 6a für Germanium aus einem Oxid auf die Si₁₋ₓGeₓ-Schicht 6 abgeschieden. Wie schon aus dem erstem Ausführungsbeispiel bekannt, weist die Oxidschicht eine Dicke von nur typischerweise 10 bis 100 nm auf. Denn eine Passivierung gegenüber einem Ätzgas, insbesondere ClF₃, muss die Diffusionsbarriere 6a nicht gewährleisten. Lediglich der Durchtritt von Ge-Atomen bei der hohen Temperatur nachfolgender Prozessschritte durch die Diffusionsbarriere in Form der dünnen Oxidschicht und nachfolgendes Eindringen in die Siliziumschicht muss verhindert werden, da diese Eindiffusion die Selektivität zur Si₁₋ₓGeₓ-Schicht 6 zunichte machen würde.

Nachfolgend wird eine erste dünne Schutzschicht 9, bevorzugt aus Siliziumoxid, mit einer möglichst guten Bedeckung der Seitenflächen der Sensorelemente abgeschieden. Die Schutzschicht 9 weist ebenfalls nur eine Dicke von 10 bis 100 nm auf, weil sie auch hier als eine Diffusionsbarriere gegenüber einem Durchtritt von Germanium aus Si₁₋ₓGeₓ-Schicht in die angrenzende Si-Schicht dient, aber keine Passivierung gegenüber einem Ätzgas, insbesondere ClF₃, gewährleisten muss. Eine Abdeckung der ersten Opferschicht durch die erste Schutzschicht 9 kann entfallen.

Im nächsten Schritt wird auf die strukturierten und mit der Schutzschicht 9 bedeckten Sensorelementen eine weitere Si₁₋ₓGeₓ-Schicht 10 aufgebracht. Diese Si₁₋ₓGeₓ-Schicht 10 dient als eine zweite Opferschicht und ist eine sogenannte Füllschicht. Die Dicke der Füllschicht wird so gewählt, dass die späteren Sensorelemente vollständig von ihr bedeckt sind. Typischerweise beträgt die Dicke der Füllschicht etwa 5 bis 30 µm. Nach der Abscheidung der Füllschicht wird eine Strukturierung der Füllschicht derart durchgeführt, dass die Füllschicht in solchen Bereichen stehen gelassen wird, in denen die späteren Sensorelemente angeordnet sind. Die Füllschicht wird über den Stützstrukturen 8 bis auf die Siliziumoxid-Schutzschicht 9 hinunter entfernt.

Auf die strukturierte Füllschicht wird eine zweite Schutzschicht 11, vorzugsweise aus Siliziumoxid, aufgebracht. Auch die zweite Schutzschicht 11 kann wie die erste Schutzschicht 9 sehr dünn sein. Eine Dicke von etwa 10 bis 100 nm reicht aus, um ein Ausdiffundieren von Germanium in die noch aufzubringende, obere Siliziumschicht 12 zu verhindern. Die zweite Schutzschicht 11 wird über den Stützstrukturen 8 derart bereichsweise entfernt, dass die beiden Schutzschichten 9, 11 auf den Stützstrukturen 8 ineinander übergehen bzw. dichtend aufeinander liegen.

Schließlich wird auf die zweite Schutzschicht 11 eine PolySiliziumschicht 12 abgeschieden, die als eine Kappenschicht 12a dient. Die Kappenschicht 12a wird mit einer Lack- oder Oxid-Maske 13 versehen und mit einem Si-Tiefenätzverfahren strukturiert. Dadurch wird die Kappenschicht 12a mit Perforationslöchern 14 versehen, die zunächst auf der zweiten Schutzschicht 11 enden. Mit Hilfe der Perforationslöcher 14 kann ein geeigtetes Ätzmedium zu den zu entfernenden Schichten zugeführt werden. Dabei werden zuerst die zweite Schutzschicht 11 und anschließend die Füllschicht, die erste Opferschicht und die erste Schutzschicht 9 entfernt. Zur Entfernung der Füllschicht und der Opferschicht aus Si₁₋ₓGeₓ 6 wird ein Ätzgas, insbesondere ClF₃, den Perforationslöchern 14 zugeführt und damit ein direkter Zugang zur Füllschicht hergestellt. Bei Prozessende ist sowohl die Füllschicht als auch die erste Opferschicht aus Si₁₋ₓGeₓ 6 vollständig oder zumindest bereichsweise um die Sensorelemente entfernt, so dass ein Hohlraum 15 entstanden ist, der mindestens ein bewegliches Sensorelement 7a aufweist.

Wie aus Fig. 6 erkennbar, werden im Anschluss an diesen Ätzschritt die Perforationslöcher 14 mit einer Abdeckschicht 16 verschlossen. Die Abdeckschicht 16 ist bevorzugt zwischen etwa 1 bis 20 µm dick und besteht beispielsweise aus einem Isolator, vorzugsweise Siliziumoxid.

Durch das oben beschriebene Verfahren wird auf eine einfache Weise ein Hohlraum 15 mit beweglichen Sensorelementen 7a auf einem Substrat Sub erzeugt. Grundsätzlich kann das Verfahren immer dann eingesetzt werden, um einen Hohlraum 15 auf einem Substrat zu bilden, wobei der Hohlraum 15 durch Entfernen einer Füllschicht aus Si₁₋ₓGeₓ mittels eines Ätzgases erzeugt wird. Der Hohlraum 15 kann bewegliche und/oder nicht-bewegliche Sensorelemente aufweisen, oder aber auch ohne jegliches Sensorelement anderen Zwecken dienen.

Neben den bisher beschriebenen Anwendungsbeispielen des erfindungsgemäßen Verfahrens zur Herstellung eines mikromechanischen Sensors mit Hilfe einer Opfer- oder Füllschicht aus Si₁₋ₓGeₓ kann das vorgeschlagene Ätzverfahren auch immer dann eingesetzt werden, wenn eine definiert steuerbare Ätzung einer Schicht oder eines Substrates notwendig bzw. erwünscht ist. So ist eine Schicht oder ein Substrat aus Silizium-Germanium-Legierung verstellbar, wobei der Gehalt an Germanium innerhalb der Legierung in einer bestimmten Richtung, beispielsweise über die Dicke der Schicht, variiert wird, um gezielt eine variierende Ätzgeschwindigkeit beim Gasphasenätzen hervorzurufen. Auch ist eine Schichtenfolge aus mehreren, einzelnen Schichten mit unterschiedlichem Ge-Gehalt geeignet, um eine selektive Ätzung zu ermöglichen. Im Extremfall kann damit ein Ätzstopp erreicht werden.

## Patentansprüche

1. Verfahren zum Ätzen einer zu entfernenden Schicht auf einem Substrat (Sub), insbesondere auf einem Silizium-Substrat, wobei die zu entfernende Schicht eine auf dem Substrat (Sub) bereits vorhandene oder eine auf dem Substrat (Sub) abgeschiedene Si₁₋ₓGeₓ-Schicht (4; 6) ist und diese Si₁₋ₓGeₓ-Schicht (4; 6) beim Gasphasenätzen mit Hilfe eines Ätzgases zumindest bereichsweise abgetragen wird, wobei vor dem Abtragen auf die Si₁₋ₓGeₓ-Schicht (4; 6) eine Siliziumschicht (5; 7) aufgewachsen und derart strukturiert wird, dass sie Si-Bereiche mit dazwischenliegenden Gräben aufweist, und anschließend zur Freilegung dieser Si-Bereiche die Si₁₋ₓGeₓ-Schicht (4; 6) als eine Opferschicht unter den freizulegenden Si-Bereichen abgetragen wird, wobei das Gasphasenätzen durch die Gräben hindurch erfolgt.

2. Verfahren nach Anspruch 1,
**dadurch gekennzeichnet,**
**dass** als Ätzgas BrF₃, XeF₂ oder ClF₃ eingesetzt wird.

3. Verfahren nach Anspruch 1 oder 2,
**dadurch gekennzeichnet,**
**dass** das Ätzverhalten der Si₁₋ₓGeₓ-Schicht (4; 6) über deren Ge-Anteil gesteuert wird.

4. Verfahren nach einem der Ansprüche 1 bis 3,
**dadurch gekennzeichnet,**
**dass** die Si₁₋ₓGeₓ-Schicht (4; 6) einen Ge-Anteil mit einem Wert x aus dem Wertebereich von x = 0,05 bis x = 0,5 aufweist.

5. Verfahren nach Anspruch 4,
**dadurch gekennzeichnet,**
**dass** die Si₁₋ₓGeₓ-Schicht (4; 6) einen Ge-Anteil mit einem Wert x aus dem Wertebereich von x = 0,1 bis x = 0,5 aufweist.

6. Verfahren nach einem der Ansprüche 1 bis 3,
**dadurch gekennzeichnet,**
**dass** die Si₁₋ₓGeₓ-Schicht (4; 6) einen Ge-Anteil mit einem Wert x aus dem Wertebereich von x = 0,05 bis x = 0,3 aufweist.

7. Verfahren nach Anspruch 6,
**dadurch gekennzeichnet,**
**dass** die Si₁₋ₓGeₓ-Schicht (4; 6) einen Ge-Anteil mit einem Wert x aus dem Wertebereich von x = 0,1 bis x = 0,3 aufweist.

8. Verfahren nach Anspruch 1,
**dadurch gekennzeichnet,**
**dass** sich zwischen der Si₁₋ₓGeₓ-Schicht (4; 6) und der Siliziumschicht (5; 7) eine Oxid- oder Nitridschicht, insbesondere mit einer Dicke von 10 bis 100 nm, als Diffusionsbarriere oder Schutzschicht (4a; 6a) befindet.

9. Verfahren nach Anspruch 1,
**dadurch gekennzeichnet,**
**dass** als Siliziumschicht (5; 7) eine Poly-Si-Schicht epitaxisch aufgewachsen wird.

10. Verfahren nach Anspruch 1,
**dadurch gekennzeichnet,**
**dass** die Strukturierung der Siliziumschicht (5; 7) mittels eines Tiefenätzverfahrens auf Fluorbasis in separaten, jeweils alternierend aufeinanderfolgenden Ätz- und Polymerisationsschritten durchgeführt wird.

11. Verfahren nach einem der Ansprüche 1 bis 10,
**dadurch gekennzeichnet,**
**dass** die S₁₋ₓGeₓ-Schicht (4) auf einem mit einer ersten Isolationsschicht (1), einer Leitschicht (2) und einer zweiten Isolationsschicht (3) beschichteten Substrat (Sub) abgeschieden wird.

12. Verfahren nach Anspruch 11,
**dadurch gekennzeichnet,**
**dass** als die erste Isolationsschicht (1) eine SiO₂-Schicht thermisch auf einem Substrat (Sub) aus Si gebildet wird.

13. Verfahren nach Anspruch 11 oder 12,
**dadurch gekennzeichnet,**
**dass** als Leitschicht (2) eine Poly-Si-Schicht aufgebracht und strukturiert wird.

14. Verfahren nach einem der Ansprüche 11 bis 13,
**dadurch gekennzeichnet,**
**dass** als die zweite Isolationsschicht (3) eine Oxidschicht aufgebracht wird.

15. Verfahren nach einem der Ansprüche 1 bis 11,
**dadurch gekennzeichnet,**
**dass** nach dem Strukturieren der Siliziumschicht (7) und vor dem Gasphasenätzen eine weitere Si₁₋ₓGeₓ-Schicht (10) als Füllschicht über den Si-Bereichen mit den dazwischen liegenden Gräben abgeschieden wird, anschließend eine Kappenschicht (12a) über der weiteren Si₁₋ₓGeₓ-Schicht (10) abgeschieden wird, dann die Kappenschicht (12a) mit Perforationslöchern (14) versehen wird, und schließlich die weitere Si₁₋ₓGeₓ-Schicht (10) und die Si₁₋ₓGeₓ-Schicht (6) durch Gasphasenätzen abgetragen werden, wobei durch die Perforationslöcher (14) das Ätzgas an die weitere Si₁₋ₓGeₓ-Schicht (10) und an die Si₁₋ₓGeₓ-Schicht (6) herangeführt wird.

## Claims

1. Method for etching a layer for removal on a substrate (sub), in particular on a silicon substrate, wherein the layer for removal is a Si₁₋ₓGeₓ layer (4; 6) already present on the substrate (sub) or deposited on the substrate (sub) and this Si₁₋ₓGeₓ layer (4; 6) is removed at least in regions during gas-phase etching with the aid of an etching gas, wherein before the removal a silicon layer (5; 7) is grown onto the Si₁₋ₓGeₓ layer (4; 6) and structured in such a way that it exhibits Si regions with interjacent trenches and subsequently, to uncover these Si regions, the Si₁₋ₓGeₓ layer (4; 6) is removed as a sacrificial layer below the Si regions to be uncovered, wherein the gas-phase etching proceeds through the trenches.

2. Method according to Claim 1,
**characterized in that**
the etching gas employed is BrF₃, XeF₂ or ClF₃.

3. Method according to Claim 1 or 2,
**characterized in that**
the etching behaviour of the Si₁₋ₓGeₓ layer (4; 6) is controlled via the Ge proportion therein.

4. Method according to any of Claims 1 to 3, **characterized in that**
the Si₁₋ₓGeₓ layer (4; 6) has a Ge proportion with a value x in the value range x = 0.05 to x = 0.5.

5. Method according to Claim 4,
**characterized in that**
the Si₁₋ₓGeₓ layer (4; 6) has a Ge proportion with a value x in the value range x = 0.1 to x = 0.5.

6. Method according to any of Claims 1 to 3, **characterized in that**
the Si₁₋ₓGeₓ layer (4; 6) has a Ge proportion with a value x in the value range x = 0.05 to x = 0.3.

7. Method according to Claim 6,
**characterized in that**
the Si₁₋ₓGeₓ layer (4; 6) has a Ge proportion with a value x in the value range x = 0.1 to x = 0.3.

8. Method according to Claim 1,
**characterized in that**
an oxide or nitride layer, in particular having a thickness of 10 to 100 nm, is located between the Si₁₋ₓGeₓ layer (4; 6) and the silicon layer (5; 7) as a diffusion barrier or protective layer (4a; 6a).

9. Method according to Claim 1,
**characterized in that**
as the silicon layer (5; 7) a poly-Si layer is epitaxially grown.

10. Method according to Claim 1,
**characterized in that**
the structuring of the silicon layer (5; 7) is performed by means of a fluorine-based deep etching process in separate, respectively alternating successive etching and polymerization steps.

11. Method according to any of Claims 1 to 10, **characterized in that**
the Si₁₋ₓGeₓ layer (4) is deposited on a substrate (sub) coated with a first insulating layer (1), a conducting layer (2) and a second insulating layer (3).

12. Method according to Claim 11,
**characterized in that**
as the first insulating layer (1) a SiO₂ layer is thermally formed on a substrate (sub) made of Si.

13. Method according to Claim 11 or 12,
**characterized in that**
as the conductive layer (2) a poly-Si layer is applied and structured.

14. Method according to any of Claims 11 to 13,
**characterized in that**
as the second insulation layer (3) an oxide layer is applied.

15. Method according to any of Claims 1 to 11,
**characterized in that**
after the structuring of the silicon layer (7) and before the gas-phase etching a further Si₁₋ₓGeₓ layer (10) is deposited as a fill layer above the Si regions having the interjacent trenches, a capping layer (12a) is subsequently deposited above the further Si₁₋ₓGeₓ layer (10), the capping layer (12a) is then provided with perforation holes (14) and the further Si₁₋ₓGeₓ layer (10) and the Si₁₋ₓGeₓ layer (6) are finally removed by gas-phase etching, wherein the etching gas is directed to the further Si₁₋ₓGeₓ layer (10) and to the Si₁₋ₓGeₓ layer (6) via the perforation holes (14).

## Revendications

1. Procédé pour graver une couche à enlever sur un substrat (Sub), en particulier sur un substrat de silicium, dans lequel la couche à enlever est une couche de Si₁₋ₓGeₓ (4 ; 6) déjà présente sur un substrat (Sub) ou déposée sur le substrat (Sub), et cette couche de Si₁₋ₓGeₓ (4 ; 6) étant enlevée au moins par endroits lors de la gravure en phase gazeuse à l'aide d'un gaz de gravure, dans lequel on fait croître sur la couche de Si₁₋ₓGeₓ (4 ; 6), avant l'enlèvement, une couche de silicium (5 ; 7), et on la structure de façon qu'elle présente des domaines de Si entre lesquels se trouvent des tranchées, puis, pour dégager ces domaines de Si, on enlève la couche de Si₁₋ₓGeₓ (4 ; 6) sous forme d'une couche sacrificielle en-dessous des domaines de Si à dégager, la gravure en phase gazeuse ayant lieu à travers les tranchées.

2. Procédé selon la revendication 1, **caractérisé en ce qu'**on utilise en tant que gaz de gravure du BrF₃, du XeF₂ ou du CIF₃.

3. Procédé selon la revendication 1 ou 2, **caractérisé en ce que** le comportement en gravure de la couche de Si₁₋ₓGeₓ (4 ; 6) est piloté par l'intermédiaire de sa teneur en Ge.

4. Procédé selon l'une des revendications 1 à 3, **caractérisé en ce que** la couche de Si₁₋ₓGeₓ (4 ; 6) présente une teneur en Ge ayant une valeur x comprise dans la plage de valeurs de x = 0,05 à x = 0,5.

5. Procédé selon la revendication 4, **caractérisé en ce que** la couche de Si₁₋ₓGeₓ (4 ; 6) présente une teneur en Ge ayant une valeur x comprise dans la plage de valeurs de x = 0,1 à x = 0,5.

6. Procédé selon l'une des revendications 1 à 3, **caractérisé en ce que** la couche de Si₁₋ₓGeₓ (4 ; 6) présente une teneur en Ge avec une valeur x comprise dans la plage de valeurs de x = 0,05 à x = 0,3.

7. Procédé selon la revendication 6, **caractérisé en ce que** la couche de Si₁₋ₓGeₓ (4 ; 6) présente une teneur en Ge ayant une valeur x comprise dans la plage de valeurs de x = 0,1 à x = 0,3.

8. Procédé selon la revendication 1, **caractérisé en ce qu'**entre la couche de Si₁₋ₓGeₓ (4 ; 6) et la couche de silicium (5 ; 7) se trouve, en tant que barrière contre une diffusion ou couche de protection (4a ; 6a) une couche d'oxyde ou de nitrure, ayant en particulier une épaisseur de 10 à 100 nm.

9. Procédé selon la revendication 1, **caractérisé en ce que**, en tant que couche de silicium (5 ; 7), on fait croître par épitaxie une couche de poly-Si.

10. Procédé selon la revendication 1, **caractérisé en ce que** la structuration de la couche de silicium (5 ; 7) est mise en oeuvre à l'aide d'un procédé de gravure profonde à base de fluor, en des étapes de gravure et de polymérisation distinctes, successives en alternance.

11. Procédé selon l'une des revendications 1 à 10, **caractérisé en ce que** la couche de Si₁₋ₓGeₓ (4) est déposée sur un substrat (Sub) revêtu d'une première couche d'isolation (1), d'une couche conductrice (2) et d'une deuxième couche d'isolation (3).

12. Procédé selon la revendication 11, **caractérisé en ce que**, en tant que première couche d'isolation (1), on forme par voie thermique une couche de SiO₂ sur un substrat (Sub) en Si.

13. Procédé selon la revendication 11 ou 12, **caractérisé en ce qu'**on applique et structure en tant que couche conductrice (2) une couche de poly-Si.

14. Procédé selon l'une des revendications 11 à 13, **caractérisé en ce qu'**on applique en tant que deuxième couche d'isolation (3) une couche d'oxyde.

15. Procédé selon l'une des revendications 1 à 11, **caractérisé en ce que**, après la structuration de la couche de silicium (7) et avant la gravure en phase gazeuse, on dépose une couche de Si₁₋ₓGeₓ (10) supplémentaire en tant que couche de remplissage sur les domaines de Si entre lesquels se trouvent les tranchées, puis on dépose une couche de couverture (12a) au-dessus de la couche de Si₁₋ₓGeₓ (10) supplémentaire, puis on pourvoit la couche de couverture (12a) de trous de perforation (14), et finalement on enlève par gravure en phase gazeuse la couche de Si₁₋ₓGeₓ (10) supplémentaire et la couche de Si₁₋ₓGeₓ (6), le gaz de gravure étant amené par les trous de perforation (14) à la couche de Si₁₋ₓGeₓ (10) supplémentaire et à la couche de Si₁₋ₓGeₓ (6).
